# EUROPEAN PATENT APPLICATION

(11) **EP 4 576 968 A1**
(43) Date of publication of application: **25.06.2025**
(21) Application number: 24847979.2
(22) Date of filing: 10.07.2024
(51) Int. Cl.: H05K 7/20, G06F 1/20

(54) **ELECTRONIC DEVICE**

(30) Priority: 03.08.2023 CN 202310975880
(71) Applicant: Huawei Technologies Co., Ltd., Shenzhen, Guangdong 518129 (CN)
(72) Inventor: ZOU, Liujun, Shenzhen, Guangdong 518129 (CN); NIU, Chenji, Shenzhen, Guangdong 518129 (CN); SHI, Jian, Shenzhen, Guangdong 518129 (CN)
(74) Representative: Grünecker Patent- und Rechtsanwälte PartG mbB
(86) International application number: PCT/CN2024/104826
(87) International publication number: WO 2025/026020

(57) **Abstract**

Embodiments of this application provide an electronic device, and relate to the field of terminal product technologies. The electronic device includes a housing assembly, a main board, a heat emitting unit, a fan, and a heat dissipation module. There is a mounting cavity in the housing assembly. The main board, the heat emitting unit, and the heat dissipation module are all disposed in the mounting cavity. The main board is mounted on the housing assembly. One side of the heat emitting unit is mounted on the main board, and another side of the heat emitting unit is connected to the heat dissipation module. The heat dissipation module and the housing assembly are disposed at an interval, and there is a thermal resistance structure between the heat dissipation module and the housing assembly. The housing assembly has an air inlet and an air outlet. Both the air inlet and the air outlet are in communication with the mounting cavity. The fan is configured to drive air at at least a part of the heat dissipation module to flow out of the mounting cavity through the air outlet. **In** this way, the fan drives air at the heat dissipation module to flow out of the housing assembly for heat dissipation. In addition, there is the thermal resistance structure between the heat dissipation module and the housing assembly, so that the housing assembly is not prone to overheating.

## Description

This application claims priority to Chinese Patent Application No. 202310975880.3, filed with the China National Intellectual Property Administration on August 3, 2023, and entitled "ELECTRONIC DEVICE", which is incorporated herein by reference in its entirety.

### TECHNICAL FIELD

Embodiments of this application relate to the field of terminal product technologies, and in particular, to an electronic device.

### BACKGROUND

As performance of an electronic device such as a mobile phone or a tablet computer is continuously enhanced, heat generated by a heat emitting unit in a housing assembly of the electronic device is increasingly high. To avoid overheating in the electronic device, the heat generated by the heat emitting unit needs to be dissipated to an external environment quickly.

In a related technology, the electronic device may include a housing assembly, a main board, and a heat emitting unit. Both the main board and the heat emitting unit are disposed in the housing assembly. The heat emitting unit is mounted on the main board. The heat emitting unit may be connected to the housing assembly through a thermal interface material (thermal interface material, TIM). In this way, heat generated by the heat emitting unit can be transferred to the housing assembly efficiently, so that the heat emitting unit dissipates the heat to an external environment through the housing assembly.

However, in the related technology, the housing assembly of the electronic device is prone to overheating.

### SUMMARY

Embodiments of this application provide an electronic device. A heat dissipation module and a fan are disposed in a housing assembly of the electronic device, so that the heat dissipation module is connected to a heat emitting unit. In addition, there is a thermal resistance structure between the heat dissipation module and the housing assembly, and the fan drives air at the heat dissipation module to flow out of the housing assembly for heat dissipation, so that the housing assembly is not prone to overheating.

This application provides an electronic device, including a housing assembly, a main board, a heat emitting unit, a fan, and a heat dissipation module. There is a mounting cavity in the housing assembly. The main board, the heat emitting unit, and the heat dissipation module are all disposed in the mounting cavity. The main board is mounted on the housing assembly. One side of the heat emitting unit is mounted on the main board, and another side of the heat emitting unit is connected to the heat dissipation module. The heat dissipation module and the housing assembly are disposed at an interval, and there is a thermal resistance structure between the heat dissipation module and the housing assembly. The housing assembly has an air inlet and an air outlet. Both the air inlet and the air outlet are in communication with the mounting cavity. The fan is configured to drive air at at least a part of the heat dissipation module to flow out of the mounting cavity through the air outlet.

According to the electronic device in this embodiment of this application, the heat dissipation module is connected to the heat emitting unit, and heat generated by the heat emitting unit may be transferred to the heat dissipation module efficiently. Because there is a thermal resistance structure between the heat dissipation module and the housing assembly, the thermal resistance structure suppresses heat transfer from the heat dissipation module to the housing assembly, and the heat generated by the heat emitting unit accumulates massively in the heat dissipation module. After the heat generated by the heat emitting unit is transferred to the heat dissipation module, the heat on the heat dissipation module is transferred to surrounding air. Air that absorbs the heat on the heat dissipation module may flow out of the mounting cavity through the air outlet under driving of the fan, and the heat generated by the heat emitting unit may be dissipated to an external environment. Air at a low temperature in the external environment may enter the mounting cavity through the air inlet, to replace the air that flows out through the air outlet. In this way, the heat generated by the heat emitting unit may be dissipated to the external environment by using an air-cooled heat dissipation module. A temperature of the heat dissipation module is high, and efficiency of performing heat exchange between the heat dissipation module and the surrounding air is high. In this way, efficiency of heat dissipation performed by the heat emitting unit through the heat dissipation module is high, so that the heat emitting unit can work at high power consumption, which is conducive to high-performance running of the electronic device. In addition, because the thermal resistance structure suppresses heat transfer from the heat dissipation module to the housing assembly, the temperature of the heat dissipation module is higher than a temperature of the housing assembly. Besides, the heat on the heat dissipation module may be dissipated to the external environment efficiently by using the air flowing out of the mounting cavity, so that the heat generated by the heat emitting unit does not accumulate massively on the housing assembly, and the housing assembly is not prone to overheating. In addition, some of the heat on the heat dissipation module may be transferred to the housing assembly through the thermal resistance structure. When the housing assembly is at a temperature at which user experience is good and performance of a component such as a display mounted on a surface of the housing assembly is not easily affected, some of the heat generated by the heat emitting unit may also be naturally dissipated through the housing assembly, and the housing assembly may play a role of assisting heat dissipation.

In a possible implementation, the heat dissipation module includes a first heat equalizing unit. The heat emitting unit is connected to the first heat equalizing unit, and the fan is configured to drive air at at least a part of the first heat equalizing unit to flow out of the mounting cavity through the air outlet.

In a possible implementation, the heat dissipation module includes a first heat equalizing unit and a heat sink. The heat emitting unit is connected to the first heat equalizing unit, and the heat sink is disposed on a surface of the first heat equalizing unit. The fan is configured to drive air at the heat sink to flow out of the mounting cavity through the air outlet.

In a possible implementation, in a length direction of the main board or in a width direction of the main board, the heat sink and the main board are disposed at an interval.

In a possible implementation, in a thickness direction of the main board, the heat emitting unit is located between the first heat equalizing unit connected to the heat emitting unit and the main board, and the first heat equalizing unit is connected to a surface of a side that is of the heat emitting unit and that faces away from the main board.

In a possible implementation, the heat sink of the heat dissipation module is disposed on a surface of a side that is of the first heat equalizing unit and that faces the main board.

In a possible implementation, the thermal resistance structure includes a gap located between the heat dissipation module and the housing assembly.

In a possible implementation, the thermal resistance structure includes a thermal resistance member disposed between the heat dissipation module and the housing assembly. One side of the thermal resistance member is connected to the heat dissipation module, and another side of the thermal resistance member is connected to the housing assembly.

In a possible implementation, the housing assembly includes a first side wall and a second heat equalizing unit. The main board includes a first side surface, and the heat emitting unit is mounted on the first side surface. The first side wall is opposite to the first side surface, the second heat equalizing unit is disposed on an inner wall of the first side wall, and the heat dissipation module is connected to the heat emitting unit mounted on the first side surface. An orthographic projection of the heat dissipation module in the thickness direction of the main board at least partially overlaps an orthographic projection of the second heat equalizing unit in the thickness direction of the main board.

In a possible implementation, there is an air duct in the housing assembly. The mounting cavity includes a ventilation cavity located in the air duct and a sealed cavity located outside the air duct. The main board and the heat emitting unit are disposed in the sealed cavity, the air duct has a through-wall hole, the heat dissipation module penetrates into the through-wall hole, and the heat dissipation module is connected to the air duct at the through-wall hole in a sealed manner, so that the ventilation cavity is separated from the sealed cavity. Both the air inlet and the air outlet are in communication with the ventilation cavity, a part that is of the heat dissipation module and that is located in the sealed cavity is connected to the heat emitting unit, and the fan is configured to drive air at a part that is of the heat dissipation module and that is located in the ventilation cavity to flow out of the ventilation cavity through the air outlet.

In a possible implementation, the fan is mounted in the mounting cavity.

In a possible implementation, the fan is mounted in the heat dissipation module.

In a possible implementation, the heat dissipation module is mounted on the main board.

In a possible implementation, the heat dissipation module is connected to the heat emitting unit through a first thermal interface material.

In a possible implementation, the electronic device further includes a controller, and the controller is electrically connected to the fan. The controller is configured to: when a temperature of the electronic device is less than a preset temperature, control the fan to be turned off, and when the temperature of the electronic device is greater than or equal to the preset temperature, control the fan to be turned on.

In a possible implementation, the main board includes a second side surface, the first side surface of the main board is disposed opposite to the second side surface, the heat emitting unit is mounted on the first side surface, and the second side surface is connected to an inner wall of the housing assembly through a second thermal interface material.

### BRIEF DESCRIPTION OF DRAWINGS

FIG. 1 is a diagram of an electronic device according to an embodiment of this application;
FIG. 2 is a diagram of another electronic device in an unfolded state according to an embodiment of this application;
FIG. 3 is a diagram of the electronic device in FIG. 2 in a folded state;
FIG. 4 is an internal diagram of still another electronic device according to an embodiment of this application;
FIG. 5 is an internal diagram of still another electronic device according to an embodiment of this application;
FIG. 6 is an internal diagram of still another electronic device according to an embodiment of this application;
FIG. 7 is a diagram of a first side wall structure and a heat dissipation module of still another electronic device from a perspective of the first side wall structure facing a side of a main board according to an embodiment of this application;
FIG. 8 is an internal diagram of still another electronic device according to an embodiment of this application;
FIG. 9 is an internal diagram of still another electronic device according to an embodiment of this application;
FIG. 10 is an internal diagram of still another electronic device according to an embodiment of this application; and
FIG. 11 is an internal diagram of still another electronic device according to an embodiment of this application.

### Reference numerals:

1: display;
2: hinge mechanism;
100: housing assembly;
110: middle frame; 120: rear cover; 130: air inlet; 140: air outlet; 150: first side wall structure; 151: first side wall; 152: second heat equalizing unit; 160: second side wall structure; 161: second side wall; 162: third heat equalizing unit; 170: enclosing wall structure;
200: heat emitting unit;
300: heat dissipation module;
310: first heat equalizing unit; 320: heat sink;
400: fan;
500: air duct;
600: mounting cavity;
610: sealed cavity; 620: ventilation cavity;
710: first gap; 720: thermal resistance member;
810: first thermal interface material; 820: second gap; 830: second thermal interface material;
900: main board;
910: first side surface; 920: second side surface; and
x: thickness direction of the main board.

### DESCRIPTION OF EMBODIMENTS

Some terms used in implementations of this application are only used to explain specific embodiments of this application, and are not intended to limit this application. The following describes the implementations of embodiments of this application in detail with reference to the accompanying drawings.

An embodiment of this application provides an electronic device. The electronic device may include but is not limited to a mobile terminal or a fixed terminal, for example, a tablet computer (portable Android device, PAD), a notebook computer, a personal digital assistant (personal digital assistant, PDA), a handheld device with a wireless communication function, a computing device, a vehicle-mounted device, a wearable device, a virtual reality (virtual reality, VR) terminal device, an augmented reality (augmented reality, AR) terminal device, a wireless terminal in industrial control (industrial control), a wireless terminal in self driving (self driving), a wireless terminal in remote medical (remote medical), a wireless terminal in a smart grid (smart grid), a wireless terminal in transportation safety (transportation safety), a wireless terminal in a smart city (smart city), and a wireless terminal in a smart home (smart home).

It may be understood that the electronic device may also be referred to as user equipment (user equipment, UE), a terminal (terminal), or the like.

In this embodiment of this application, an example in which the electronic device is a handheld device with a wireless communication function is used for description, and the handheld device with a wireless communication function may be a mobile phone.

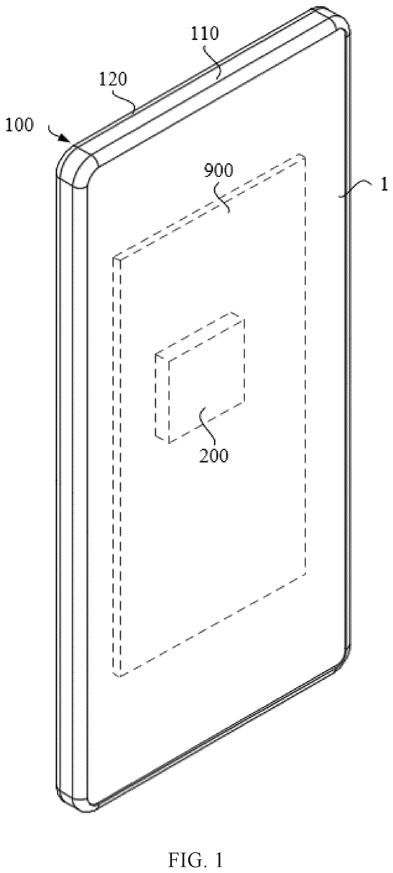

FIG. 1 is a diagram of an electronic device according to an embodiment of this application.

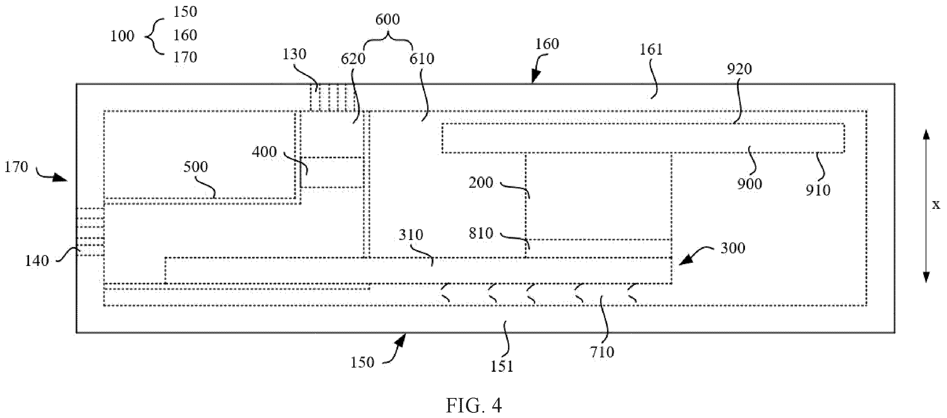

As shown in FIG. 1, in this embodiment of this application, the electronic device includes a housing assembly 100, a main board 900, a heat emitting unit 200, and a display 1. The display 1 is mounted on a surface of the housing assembly 100. There is a mounting cavity 600 in the housing assembly 100 (as shown in FIG. 4 below). The main board 900 and the heat emitting unit 200 are disposed in the mounting cavity 600. The main board 900 is mounted on the housing assembly 100. The heat emitting unit 200 is mounted on the main board 900 and is electrically connected to the main board 900. The display 1 may be electrically connected to the main board 900 through a flat cable.

It may be understood that the heat emitting unit 200 may be mounted on only one side of the main board 900, or the heat emitting unit 200 may be mounted on both sides of the main board 900.

For example, the display 1 may be mounted on the surface of the housing assembly 100 in a manner of bonding, clamping, or the like.

For example, the main board 900 may be mounted on an inner wall of the housing assembly 100 in a manner of fastener connection, clamping, or the like.

For example, the heat emitting unit 200 may include one or more heat emitting devices. For example, the heat emitting unit 200 may include one or more of heat emitting devices such as a chip and a power supply. The chip may be a central processing unit (central processing unit, CPU), a graphics processing unit (graphics processing unit, GPU), a data processing unit (data processing unit, DPU), or the like.

For example, a thickness direction of the main board 900 may be the same as a thickness direction of the housing assembly 100 in which the main board 900 is located.

In this embodiment of this application, the housing assembly 100 may include a middle frame 110 and a rear cover 120. The rear cover 120 covers and is connected to one side of the middle frame 110 in a thickness direction. The display 1 may be mounted on the other side of the middle frame 110 in the thickness direction. Two sides of the middle frame 110 in the thickness direction may be respectively used to carry the display 1 and the rear cover 120. The mounting cavity 600 is formed between the middle frame 110 and the rear cover 120.

For example, the main board 900 may be mounted on the middle frame 110 in a manner of fastener connection, clamping, or the like.

For example, the display 1 may be mounted on a surface of the middle frame 110 in a manner of bonding, clamping, or the like.

For example, the rear cover 120 may be mounted on the middle frame 110 in a manner of bonding, clamping, fastener connection, or the like.

In some examples, the electronic device may include a plurality of displays 1, and in addition to the display 1 mounted on the middle frame 110, the display 1 may alternatively be mounted on the rear cover 120.

For example, the display 1 located on the rear cover 120 may be mounted on the rear cover 120 in a manner of bonding, clamping, or the like.

In some embodiments of this application, the electronic device may be a non-foldable device. For example, the electronic device may be a phablet, a tablet computer, or the like. When the electronic device is a non-foldable device, the electronic device may include one housing assembly 100.

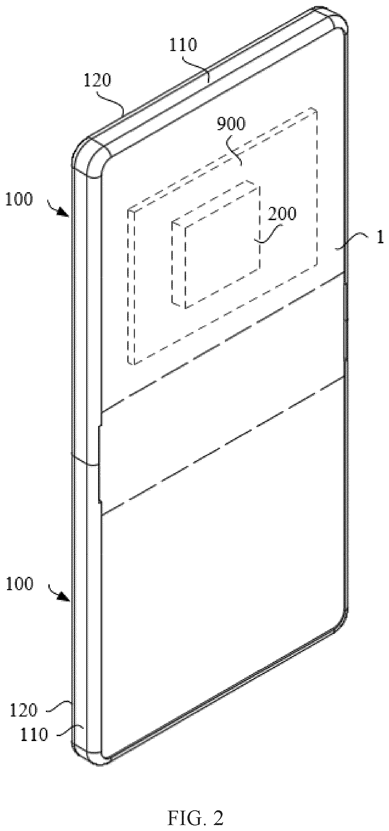

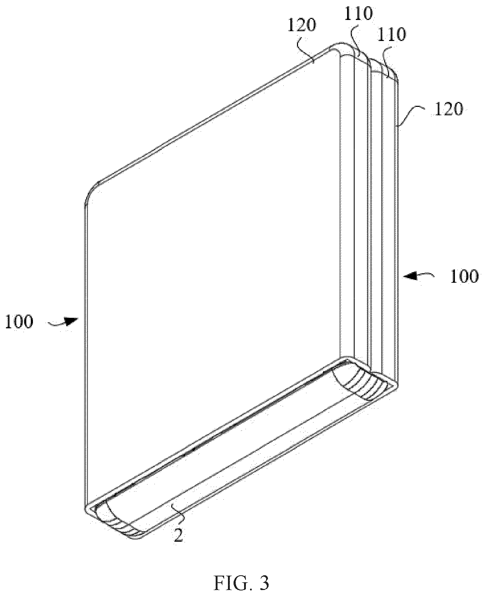

FIG. 2 is a diagram of another electronic device in an unfolded state according to an embodiment of this application. FIG. 3 is a diagram of the electronic device in FIG. 2 in a folded state.

As shown in FIG. 2 and FIG. 3, in some other embodiments of this application, the electronic device may be a foldable device having an unfolded state and a folded state. For example, the electronic device may be a foldable mobile phone, a notebook computer, or the like. When the electronic device is a foldable device, the electronic device includes at least two housing assemblies 100 and a hinge mechanism 2 disposed between the two housing assemblies 100. The two adjacent housing assemblies 100 are rotatably connected through the hinge mechanism 2. The two adjacent housing assemblies 100 rotate oppositely and backwards, so that the electronic device can be switched between the unfolded state and the folded state.

When the electronic device is a foldable device, the electronic device may include two, three, four, or more housing assemblies 100, and the electronic device may be an electronic device that can be folded into two layers, three layers, four layers, or more layers.

When the electronic device is in an unfolded state, all housing assemblies 100 may be arranged in a length direction or a width direction of the electronic device.

When the electronic device is a foldable device, some housing assemblies 100 may be used to mount the display 1, and some housing assemblies 100 are not used to mount the display 1. Alternatively, all the housing assemblies 100 may be used to mount the display 1.

When the electronic device is a foldable device, the display 1 may be a flexible display, and the flexible display may be mounted on surfaces of the plurality of housing assemblies 100. Specifically, the flexible display may be mounted on middle frames 110 of the plurality of housing assemblies 100, and the flexible display may be folded and unfolded under driving of the housing assemblies 100.

When the electronic device is a foldable device, different displays 1 may be respectively mounted on surfaces of the at least two housing assemblies 100.

When the electronic device is a foldable device, each housing assembly 100 has a mounting cavity 600, and a main board 900 and a heat emitting unit 200 are mounted in the mounting cavity 600 of at least one housing assembly 100. When main boards 900 are mounted in the mounting cavities 600 of the plurality of housing assemblies 100, the main boards 900 in the mounting cavities 600 of the different housing assemblies 100 may be connected through a flexible printed circuit board.

In a related technology, the heat emitting unit may be connected to the inner wall of the housing assembly through a thermal interface material (thermal interface material, TIM). In this way, heat generated by the heat emitting unit can be transferred to the housing assembly efficiently, so that heat generated by the heat emitting unit is dissipated to an external environment through the housing assembly.

In the related technology, because the heat emitting unit mainly relies on the housing assembly for heat dissipation, the heat generated by the heat emitting unit needs to be efficiently transferred to the housing assembly, and a large amount of heat accumulation is prone to occur on the housing assembly, resulting in overheating of the housing assembly. After the housing assembly is overheated, user experience is affected, and performance of a component such as the display mounted on the surface of the housing assembly is easily affected. In addition, on a basis that user experience is good and performance of a component such as the display mounted on the surface of the housing assembly is not easily affected, a maximum temperature allowed to be reached by the housing assembly is limited, that is, a temperature of the housing assembly is not excessively high. After the maximum temperature allowed to be reached by the housing assembly is limited, a temperature difference between the housing assembly and the external environment is small. As a result, efficiency of heat dissipation performed by the heat emitting unit through the housing assembly is low, and power consumption of the heat emitting unit is limited, which is not conducive to high-performance running of the electronic device.

FIG. 4 is an internal diagram of still another electronic device according to an embodiment of this application. An x direction is a thickness direction of the main board.

As shown in FIG. 4, with reference to FIG. 1 to FIG. 3, based on this, in this embodiment of this application, the electronic device further includes a fan 400 and a heat dissipation module 300. The heat dissipation module 300 is disposed in the mounting cavity 600. The main board 900 is mounted on the housing assembly 100. One side of the heat emitting unit 200 is mounted on the main board 900, and another side of the heat emitting unit 200 is connected to the heat dissipation module 300. The heat dissipation module 300 and the housing assembly 100 are disposed at an interval. That is, the heat dissipation module 300 does not directly contact the housing assembly 100. There is a thermal resistance structure between the heat dissipation module 300 and the housing assembly 100. The housing assembly 100 has an air inlet 130 and an air outlet 140. Both the air inlet 130 and the air outlet 140 are in communication with the mounting cavity 600. The fan 400 is mounted on the housing assembly 100, and the fan 400 is configured to drive air at at least a part of the heat dissipation module 300 to flow out of the mounting cavity 600 through the air outlet 140.

It may be understood that the thermal resistance structure is configured to suppress heat transfer between the heat dissipation module 300 and the housing assembly 100. When heat is transferred from the heat dissipation module 300 to the housing assembly 100 through the thermal resistance structure, a temperature of the heat dissipation module 300 is higher than a temperature of the housing assembly 100. When heat is transferred from the housing assembly 100 to the heat dissipation module 300 through the thermal resistance structure, the temperature of the housing assembly 100 is higher than the temperature of the heat dissipation module 300.

It should be noted that the thermal resistance structure does not completely isolate heat transfer between the heat dissipation module 300 and the housing assembly 100. When there is a temperature difference between the heat dissipation module 300 and the housing assembly 100, heat transfer may be performed between the heat dissipation module 300 and the housing assembly 100 at a low thermal conductivity.

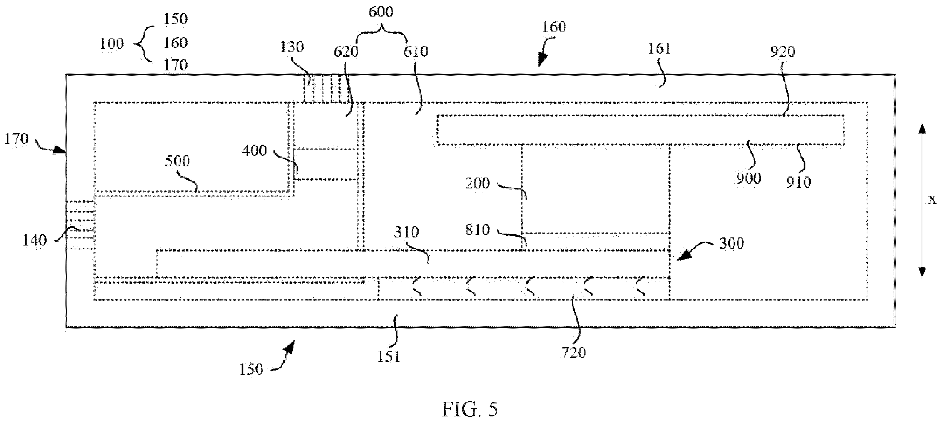

For example, the thermal resistance structure may include one or more of a first gap 710, a thermal resistance member 720 (as shown in FIG. 5 below), and the like that are located between the heat dissipation module 300 and the housing assembly 100.

In this way, the heat dissipation module 300 is connected to the heat emitting unit 200, and heat generated by the heat emitting unit 200 may be transferred to the heat dissipation module 300 efficiently. Because there is a thermal resistance structure between the heat dissipation module 300 and the housing assembly 100, the thermal resistance structure suppresses heat transfer from the heat dissipation module 300 to the housing assembly 100, and the heat generated by the heat emitting unit 200 accumulates massively in the heat dissipation module 300. After the heat generated by the heat emitting unit 200 is transferred to the heat dissipation module 300, the heat on the heat dissipation module 300 is transferred to surrounding air. Air that absorbs the heat on the heat dissipation module 300 may flow out of the mounting cavity 600 through the air outlet 140 under driving of the fan 400, and the heat generated by the heat emitting unit 200 may be dissipated to an external environment. Air at a low temperature in the external environment may enter the mounting cavity 600 through the air inlet 130, to replace the air that flows out through the air outlet 140. In this way, the heat generated by the heat emitting unit 200 may be dissipated to the external environment by using an air-cooled heat dissipation module 300. A temperature of the heat dissipation module 300 is high, and efficiency of performing heat exchange between the heat dissipation module 300 and the surrounding air is high. In this way, efficiency of heat dissipation performed by the heat emitting unit 200 through the heat dissipation module 300 is high, so that the heat emitting unit 200 can work at high power consumption, which is conducive to high-performance running of the electronic device. In addition, because the thermal resistance structure suppresses heat transfer from the heat dissipation module 300 to the housing assembly 100, the temperature of the heat dissipation module 300 is higher than a temperature of the housing assembly 100. Besides, the heat on the heat dissipation module 300 may be dissipated to the external environment efficiently by using the air flowing out of the mounting cavity 600, so that the heat generated by the heat emitting unit 200 does not accumulate massively on the housing assembly 100, and the housing assembly 100 is not prone to overheating. In addition, some of the heat on the heat dissipation module 300 may be transferred to the housing assembly 100 through the thermal resistance structure. When the housing assembly 100 is at a temperature at which user experience is good and performance of a component such as a display 1 mounted on a surface of the housing assembly 100 is not easily affected, some of the heat generated by the heat emitting unit 200 may also be naturally dissipated through the housing assembly 100, and the housing assembly 100 may play a role of assisting heat dissipation.

It may be understood that, because a thermal resistance of the main board 900 is large, the heat generated by the heat emitting unit 200 is more easily dissipated through the heat dissipation module 300, and it is not easy to transfer the heat to the housing assembly 100 through the main board 900.

It may be understood that, except a part that is of the heat dissipation module 300 and that is configured to connect to the heat emitting unit 200, there is a thermal resistance structure between the remaining part of the heat dissipation module 300 and the housing assembly 100. When the heat emitting unit 200 dissipates heat through the heat dissipation module 300, the heat is transferred from the heat emitting unit 200 to the heat dissipation module 300, and the heat on the heat dissipation module 300 is not transferred to the housing assembly 100 through the heat emitting unit 200.

It may be understood that the thermal resistance structure may be adjusted based on heat that can be generated by the heat emitting unit 200, to adjust a thermal resistance between the heat dissipation module 300 and the housing assembly 100, so that the temperature of the housing assembly 100 and a capability of the housing assembly 100 to perform natural heat dissipation on the heat generated by the heat emitting unit 200 can be considered.

It may be understood that, after air that absorbs the heat on the heat dissipation module 300 in the mounting cavity 600 flows out of the mounting cavity 600 from the air outlet 140, air at a low temperature outside the housing assembly 100 flows into the mounting cavity 600 through the air inlet 130.

In an embodiment in which the housing assembly 100 includes the middle frame 110 and the rear cover 120, at least one of the middle frame 110 and the rear cover 120 has the air inlet 130, and at least one of the middle frame 110 and the rear cover 120 has the air outlet 140.

For example, the fan 400 may be electrically connected to the main board 900.

In this embodiment of this application, the electronic device may further include a controller (not shown), and the controller is electrically connected to the fan 400. The controller may be configured to: when a temperature of the electronic device is less than a preset temperature, control the fan 400 to be turned off, and when the temperature of the electronic device is greater than or equal to the preset temperature, control the fan 400 to be turned on.

In this way, when the temperature of the electronic device is low, the fan 400 may be turned off, the heat generated by the heat emitting unit 200 may be transferred from the heat dissipation module 300 to the housing assembly 100 through the thermal resistance structure, and the heat is dissipated to the external environment through natural heat dissipation of the housing assembly 100. After the fan 400 is turned off, noise and energy consumption of the electronic device may be reduced. When the temperature of the electronic device is high, the fan 400 may be turned on, and the heat generated by the heat emitting unit 200 may be dissipated through the air-cooled heat dissipation module 300, so that the heat generated by the heat emitting unit 200 can be dissipated to the external environment efficiently, and overheating is not prone to occur in the heat emitting unit 200 and the heat dissipation module 300. In addition, the fan 400 is controlled based on the temperature of the electronic device, which is applicable to both high and low temperatures of the external environment. A control parameter does not need to be adjusted based on a temperature of the external environment, and control over the fan 400 is simple and convenient.

It may be understood that the temperature of the electronic device may include one or more of a temperature of the heat emitting unit 200, the temperature of the main board 900, the temperature of the housing assembly 100, a temperature of the heat dissipation module 300, an environment temperature in the mounting cavity 600, and the like. Correspondingly, the preset temperature may include one or more of a preset temperature of the heat emitting unit 200, a preset temperature of the main board 900, a preset temperature of the housing assembly 100, a preset temperature of the heat dissipation module 300, a preset environment temperature in the mounting cavity 600, and the like.

For example, the temperature of the electronic device may include the temperature of the heat emitting unit 200, and correspondingly, the preset temperature includes the preset temperature of the heat emitting unit 200. The controller may be configured to: when the temperature of the heat emitting unit 200 is less than the preset temperature of the heat emitting unit 200, control the fan 400 to be turned off, and when the temperature of the heat emitting unit 200 is greater than or equal to the preset temperature of the heat emitting unit 200, control the fan 400 to be turned on.

For another example, the temperature of the electronic device may include the environment temperature in the mounting cavity 600, and correspondingly, the preset temperature includes the preset environment temperature in the mounting cavity 600. The controller may be configured to: when the environment temperature in the mounting cavity 600 is less than the preset environment temperature in the heat-emitting mounting cavity 600, control the fan 400 to be turned off, and when the environment temperature in the mounting cavity 600 is greater than or equal to the preset environment temperature in the mounting cavity 600, control the fan 400 to be turned on.

In some examples, the electronic device may further include a temperature sensor (not shown). The temperature sensor is configured to obtain the temperature of the electronic device. The temperature sensor is electrically connected to the controller. The controller is configured to control turn-on/off of the fan 400 based on the temperature of the electronic device obtained by the temperature sensor and the preset temperature.

When the heat emitting unit 200 includes a processor, the temperature sensor may be electrically connected to the controller through the processor of the heat emitting unit 200. The processor may be configured to form, based on the temperature of the electronic device obtained by the temperature sensor and the preset temperature, a control instruction for controlling the fan 400, and send the control instruction to the controller. The controller may control the fan 400 according to the control instruction.

For example, the electronic device may include a first temperature sensor disposed at the heat emitting unit 200. The first temperature sensor is configured to obtain the temperature of the heat emitting unit 200. The first temperature sensor is electrically connected to the controller. The controller is configured to control turn-on/off of the fan 400 based on the temperature of the heat emitting unit 200 obtained by the first temperature sensor and the preset temperature of the heat emitting unit 200.

For another example, the electronic device may include a second temperature sensor disposed in the mounting cavity 600. The second temperature sensor is configured to obtain the environment temperature in the mounting cavity 600. The second temperature sensor is electrically connected to the controller. The controller is configured to control turn-on/off of the fan 400 based on the environment temperature in the mounting cavity 600 obtained by the second temperature sensor and the preset environment temperature in the mounting cavity 600.

For example, the controller may be mounted on the main board 900 and electrically connected to the main board 900, and the controller may be electrically connected to the fan 400 through the main board 900.

In this embodiment of this application, the housing assembly 100 includes a first side wall structure 150, a second side wall structure 160, and an enclosing wall structure 170. The first side wall structure 150 and the second side wall structure 160 are disposed opposite to each other in a thickness direction of the housing assembly 100, and are disposed at an interval. Two ends of the enclosing wall structure 170 in the thickness direction of the housing assembly 100 are respectively connected to the first side wall structure 150 and the second side wall structure 160, so that the mounting cavity 600 is formed between the first side wall structure 150, the second side wall structure 160, and the enclosing wall structure 170. The heat dissipation module 300 is disposed at an interval with the first side wall structure 150, the second side wall structure 160, and the enclosing wall structure 170. In other words, the heat dissipation module 300 is not in direct contact with the first side wall structure 150, the second side wall structure 160, and the enclosing wall structure 170. There is a thermal resistance structure between the heat dissipation module 300 and each of the first side wall structure 150, the second side wall structure 160, and the enclosing wall structure 170.

In an embodiment in which the housing assembly 100 includes the middle frame 110 and the rear cover 120, the middle frame 110 may include the first side wall structure 150. In this case, the rear cover 120 includes the second side wall structure 160. Alternatively, the rear cover 120 may include the first side wall structure 150. In this case, the middle frame 110 includes the second side wall structure 160.

In some examples, the middle frame 110 includes the enclosing wall structure 170.

In some other examples, the rear cover 120 includes the enclosing wall structure 170.

In some other examples, the enclosing wall structure 170 includes a first part and a second part. The middle frame 110 includes the first part, the rear cover 120 includes the second part, and the first part and the second part are spliced to form the enclosing wall structure 170.

In this embodiment of this application, the main board 900 includes a first side surface 910 and a second side surface 920. The first side surface 910 and the second side surface 920 are disposed opposite to each other in the thickness direction of the main board 900. The first side wall structure 150 and the first side surface 910 are opposite to each other, and the second side wall structure 160 and the second side surface 920 are opposite to each other. The heat emitting unit 200 is mounted on the first side surface 910. For the heat dissipation module 300 connected to the heat emitting unit 200 mounted on the first side surface 910, a thermal resistance between the heat dissipation module 300 and the first side wall structure 150 is less than a thermal resistance between the heat dissipation module 300 and the second side wall structure 160, and the thermal resistance between the heat dissipation module 300 and the first side wall structure 150 is less than a thermal resistance between the heat dissipation module 300 and the enclosing wall structure 170. In other words, the heat dissipation module 300 transfers heat to the housing assembly 100 mainly through the first side wall structure 150. The thermal resistance between the heat dissipation module 300 and the first side wall structure 150 determines a thermal conductivity between the heat dissipation module 300 and the housing assembly 100.

In this embodiment of this application, the first side wall structure 150 includes a first side wall 151, the second side wall structure 160 includes a second side wall 161, and the two ends of the enclosing wall structure 170 in the thickness direction of the housing assembly 100 are respectively connected to the first side wall 151 and the second side wall 161.

In some examples, the first side wall 151 is configured to mount the display 1, at least one of the second side wall 161 and the enclosing wall structure 170 has the air inlet 130, and at least one of the second side wall 161 and the enclosing wall structure 170 has the air outlet 140. In this way, the display 1 is less affected by the air inlet 130 and the air outlet 140 that are disposed.

In some examples, the fan 400 is mounted on an outer wall of the housing assembly 100, and the fan 400 may exhaust air towards the air inlet 130. This is conducive to saving mounting space in the mounting cavity 600.

As shown in FIG. 4, in some other examples, the fan 400 is mounted in the mounting cavity 600. This is conducive to driving an air flow at the heat dissipation module 300, so that heat dissipation efficiency of the heat dissipation module 300 is higher. In addition, in comparison with the solution in which the fan 400 is mounted on the outer wall of the housing assembly 100, the housing assembly 100 may protect the fan 400, so that the fan 400 is not easily damaged. In addition, a protruding structure outside the housing assembly 100 may also be reduced, so that the electronic device is convenient for use and storage.

In some examples of this application, there is an air duct 500 in the housing assembly 100. The mounting cavity 600 includes a ventilation cavity 620 located in the air duct 500 and a sealed cavity 610 located outside the air duct 500. The main board 900 and the heat emitting unit 200 are disposed in the sealed cavity 610, the air duct 500 has a through-wall hole (not shown), the heat dissipation module 300 penetrates into the through-wall hole, and the heat dissipation module 300 is connected to the air duct 500 at the through-wall hole in a sealed manner, so that the ventilation cavity 620 is separated from the sealed cavity 610. Both the air inlet 130 and the air outlet 140 are in communication with the ventilation cavity 620, a part that is of the heat dissipation module 300 and that is located in the sealed cavity 610 is connected to the heat emitting unit 200, and the fan 400 is configured to drive air at a part that is of the heat dissipation module 300 and that is located in the ventilation cavity 620 to flow out of the ventilation cavity 620 through the air outlet 140.

In this way, on a basis that heat dissipation may be performed on the heat emitting unit 200 through the air-cooled heat dissipation module 300, it is convenient to seal a cavity in which components such as the heat emitting unit 200 and the main board 900 are located, so that water, dust, and the like do not easily enter the cavity in which the components such as the main board 900 and the heat emitting unit 200 are located, which is conducive to dust-proof and water-proof design of the electronic device.

In an embodiment in which there is an air duct 500 in the housing assembly 100, the fan 400 may be mounted in the ventilation cavity 620.

When the fan 400 is mounted in the ventilation cavity 620, the fan 400 may be electrically connected to the main board 900 through a cable passing through the air duct 500, and the cable is connected to the air duct 500 at a position passing through the air duct 500 in a sealed manner.

For example, the air duct 500 may be formed by splicing structures on the middle frame 110 and the rear cover 120.

For example, one of the second side wall 161 and the enclosing wall structure 170 has the air inlet 130, and the other of the second side wall 161 and the enclosing wall structure 170 has the air outlet 140. In this way, the air duct 500 can be easily disposed.

In some other examples of this application, the air inlet 130 and the air outlet 140 may alternatively be connected to the cavity in which the main board 900 and the heat emitting unit 200 are located. In this case, the main board 900, the heat emitting unit 200, the heat dissipation module 300, and the fan 400 may be located in a same cavity, and the fan 400 may be configured to drive air at the main board 900, the heat emitting unit 200, and the heat dissipation module 300 to flow out of the mounting cavity 600 through the air outlet 140. In this way, heat dissipation efficiency of the heat emitting unit 200 is high.

In some examples, the thermal resistance structure may be a first gap 710 located between the heat dissipation module 300 and the housing assembly 100. In this way, a structure between the heat dissipation module 300 and the housing assembly 100 is simple, and no other thermal resistance member needs to be disposed at the first gap 710, so that costs of the electronic device are low. In addition, the thermal resistance between the heat dissipation module 300 and the housing assembly 100 may be adjusted by using a size of the first gap 710, and it is convenient to adjust the thermal resistance between the heat dissipation module 300 and the housing assembly 100.

It may be understood that gas in the first gap 710 may be used as thermal resistance between the heat dissipation module 300 and the housing assembly 100, to suppress heat transfer between the heat dissipation module 300 and the housing assembly 100.

It may be understood that sizes of first gaps 710 between different parts of the heat dissipation module 300 and the housing assembly 100 may be different. Specifically, when the heat emitting unit 200 is mounted on the first side surface 910, for the heat dissipation module 300 connected to the heat emitting unit 200 mounted on the first side surface 910, a first gap 710 between the heat dissipation module 300 and the first side wall structure 150 is less than a first gap 710 between the heat dissipation module 300 and the second side wall structure 160. When the heat emitting unit 200 is mounted on the second side surface 920, for the heat dissipation module 300 connected to the heat emitting unit 200 mounted on the second side surface 920, the first gap 710 between the heat dissipation module 300 and the second side wall structure 160 is less than the first gap 710 between the heat dissipation module 300 and the first side wall structure 150.

In this embodiment of this application, the heat dissipation module 300 is connected to the heat emitting unit 200 through a first thermal interface material 810. This is conducive to transferring the heat generated by the heat emitting unit 200 to the heat dissipation module 300 efficiently.

FIG. 5 is an internal diagram of still another electronic device according to an embodiment of this application.

As shown in FIG. 5, in some examples, the thermal resistance structure includes a thermal resistance member 720 disposed between the heat dissipation module 300 and the housing assembly 100. One side of the thermal resistance member 720 is connected to the heat dissipation module 300, and another side of the thermal resistance member 720 is connected to the housing assembly 100. In this way, the thermal resistance between the heat dissipation module 300 and the housing assembly 100 at a same interval may be changed by changing a material of the thermal resistance member 720. When the thermal resistance between the heat dissipation module 300 and the housing assembly 100 is adjusted, a relative position between the heat dissipation module 300 and the housing assembly 100 may not be changed, and the thermal resistance between the heat dissipation module 300 and the housing assembly 100 is adjusted flexibly. In this way, when an interval between the heat dissipation module 300 and the housing assembly 100 is small, the thermal resistance between the heat dissipation module 300 and the housing assembly 100 is large, and when the interval between the heat dissipation module 300 and the housing assembly 100 is large, the thermal resistance between the heat dissipation module 300 and the housing assembly 100 is reduced.

For example, the thermal resistance member 720 may be made of a material such as silicone, rubber, or plastic.

For example, the thermal resistance structure may include the first gap 710 and the thermal resistance member 720. Both the first gap 710 and the thermal resistance member 720 are located between the heat dissipation module 300 and the housing assembly 100. There is a first gap 710 between a part of the heat dissipation module 300 and the housing assembly 100, and there is a thermal resistance member 720 between a part of the heat dissipation module 300 and the housing assembly 100.

In this embodiment of this application, the heat dissipation module 300 includes a first heat equalizing unit 310, and the heat emitting unit 200 is connected to the first heat equalizing unit 310. In this way, temperatures at all parts of the first heat equalizing unit 310 are balanced, and efficiency of heat exchange between the first heat equalizing unit 310 and surrounding air is high, which helps improve efficiency of heat dissipation performed by the heat emitting unit 200 through the heat dissipation module 300.

For example, the first heat equalizing unit 310 may include one or more of a vapor chamber (vapor chamber, VC), a heat pipe, and the like.

In an embodiment in which the heat dissipation module 300 includes the first heat equalizing unit 310, the first heat equalizing unit 310 is connected to the heat emitting unit 200 through the first thermal interface material 810.

In some examples, the fan 400 is configured to drive air at at least a part of the first heat equalizing unit 310 to flow out of the mounting cavity 600 through the air outlet 140. In this way, heat dissipation may be performed by heat exchange between a surface of the first heat equalizing unit 310 and the surrounding air. The first heat equalizing unit 310 occupies small space, which is conducive to disposing the heat dissipation module 300 in narrow space.

In some embodiments in which the air duct 500 is disposed in the housing assembly 100, the first heat equalizing unit 310 of the heat dissipation module 300 penetrates into the through-wall hole. The first heat equalizing unit 310 is connected to the air duct 500 at the through-wall hole in a sealed manner. A part of the first heat equalizing unit 310 is located in the sealed cavity 610, and a part of the first heat equalizing unit 310 is located in the ventilation cavity 620. The part that is of the first heat equalizing unit 310 and that is located in the sealed cavity 610 is connected to the heat emitting unit 200. The fan 400 is configured to drive air at the part that is of the first heat equalizing unit 310 and that is located in the ventilation cavity 620 to flow out of the ventilation cavity 620 through the air outlet 140.

In this embodiment of this application, in the thickness direction of the main board 900, the heat emitting unit 200 is located between the first heat equalizing unit 310 connected to the heat emitting unit 200 and the main board 900, and the first heat equalizing unit 310 is connected to a surface of a side that is of the heat emitting unit 200 and that faces away from the main board 900. In this way, interference between the first heat equalizing unit 310 and the main board 900 does not easily occur, and the first heat equalizing unit 310 is conveniently connected to the heat emitting unit 200. In addition, this is conducive to arrangement of the first heat equalizing unit 310 with a large size, so that efficiency of heat dissipation performed by the heat emitting unit 200 through the first heat equalizing unit 310 is improved.

For example, the first heat equalizing unit 310 and the main board 900 may be disposed at an interval in the thickness direction of the main board 900, and the first heat equalizing unit 310 may extend in a direction perpendicular to the thickness direction of the main board 900.

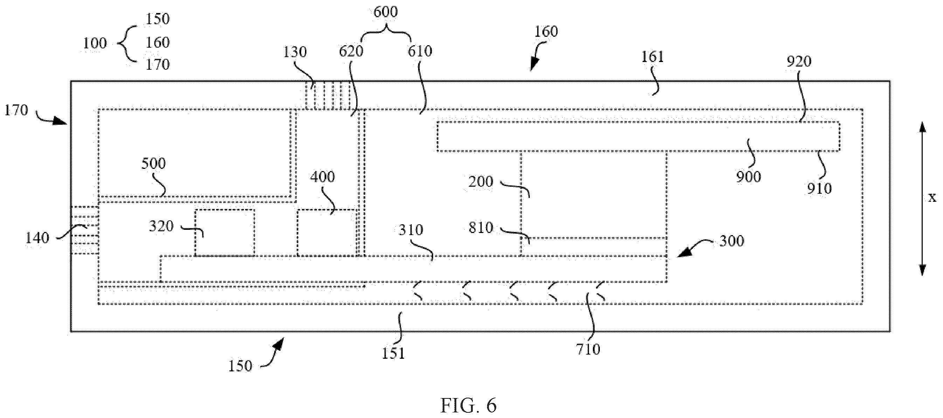

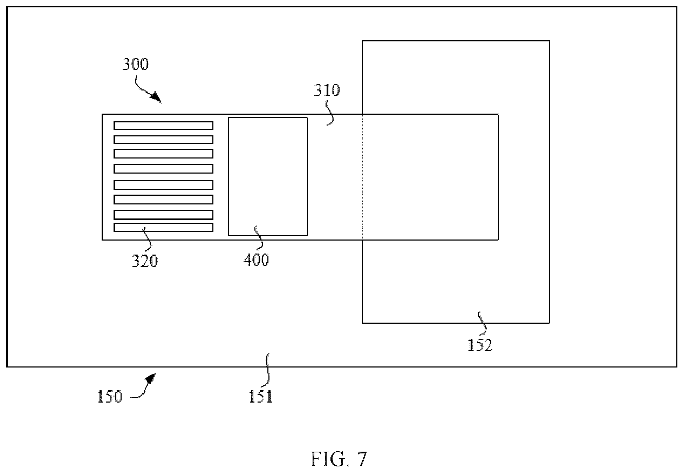

FIG. 6 is an internal diagram of still another electronic device according to an embodiment of this application. FIG. 7 is a diagram of a first side wall structure and a heat dissipation module of still another electronic device from a perspective of the first side wall structure facing a side of a main board according to an embodiment of this application.

As shown in FIG. 6 and FIG. 7, in some examples, the heat dissipation module 300 further includes a heat sink 320. The heat sink 320 is disposed on the surface of the first heat equalizing unit 310, and the fan 400 is configured to drive air at the heat sink 320 to flow out of the mounting cavity 600 through the air outlet 140.

In this way, a heat exchange surface between the heat dissipation module 300 and the surrounding air is large, and efficiency of heat exchange between the heat dissipation module 300 and the surrounding air is high, which helps improve efficiency of heat dissipation performed by the heat emitting unit 200 through the heat dissipation module 300.

In some embodiments in which the air duct 500 is disposed in the housing assembly 100, the first heat equalizing unit 310 is located in the sealed cavity 610. Through-wall holes and heat sinks 320 are disposed in a one-to-one correspondence. The heat sinks 320 penetrate into corresponding through-wall holes. The heat sinks 320 are connected to the air duct 500 at the corresponding through-wall holes in a sealed manner. The fan 400 is configured to drive air at a part that is of the heat sinks 320 and that is located in the ventilation cavity 620 to flow out of the ventilation cavity 620 through the air outlet 140.

As shown in FIG. 6, in some other embodiments in which the air duct 500 is disposed in the housing assembly 100, the first heat equalizing unit 310 of the heat dissipation module 300 penetrates into the through-wall hole. The first heat equalizing unit 310 is connected to the air duct 500 at the through-wall hole in a sealed manner. A part that is of the first heat equalizing unit 310 and that is located in the sealed cavity 610 is connected to the heat emitting unit 200. The heat sink 320 of the heat dissipation module 300 is disposed on a surface of a part that is of the first heat equalizing unit 310 and that is located in the ventilation cavity 620. The fan 400 is configured to drive air at the heat sink 320 and at the part that is of the first heat equalizing unit 310 and that is located in the ventilation cavity 620 to flow out of the ventilation cavity 620 through the air outlet 140. In this way, assembly between the heat dissipation module 300 and the air duct 500 is easy.

In an embodiment in which the heat dissipation module 300 includes the first heat equalizing unit 310 and the heat sink 320, in a length direction of the main board 900 or in a width direction of the main board 900, the heat sink 320 and the main board 900 are disposed at an interval. In this way, the heat sink 320 does not interfere with the main board 900 easily, which is conducive to arranging the heat sink 320 with a large size on the surface of the first heat equalizing unit 310, so that efficiency of heat dissipation performed by the heat emitting unit 200 through the heat dissipation module 300 is high.

In an embodiment in which the heat dissipation module 300 includes the first heat equalizing unit 310 and the heat sink 320, the heat sink 320 of the heat dissipation module 300 is disposed on a surface of a side that is of the first heat equalizing unit 310 and that faces the main board 900. In this way, in the thickness direction of the main board 900, at least a part of the heat sink 320 may be located between the first heat equalizing unit 310 and the main board 900, which is conducive to reducing a size of the housing assembly 100. In addition, there is a large interval between the housing assembly 100 and the side that is of the first heat equalizing unit 310 and that faces the main board 900, which is also conducive to arranging the heat sink 320 with a large size on the first heat equalizing unit 310, so that efficiency of heat dissipation performed by the heat emitting unit 200 through the heat dissipation module 300 is high. In addition, this is also conducive to adjusting the thermal resistance structure between the housing assembly 100 and a side that is of the first heat equalizing unit 310 and that faces away from the main board 900, which facilitates control over a thermal conductivity between the heat dissipation module 300 and the housing assembly 100. Moreover, this is also conducive to reducing an interval between the housing assembly 100 and the side that is of the first heat equalizing unit 310 and that faces away from the main board 900.

It may be understood that, in an embodiment in which the heat sink 320 is disposed on the surface of the side that is of the first heat equalizing unit 310 and that faces the main board 900, the heat dissipation module 300 transfers heat to the housing assembly 100 mainly through the side that is of the first heat equalizing unit 310 and that faces away from the main board 900.

For example, a plurality of heat sinks 320 spaced apart from each other are disposed in parallel on the surface of the side that is of the first heat equalizing unit 310 and that faces the main board 900.

It may be understood that the heat dissipation module 300 may include the first heat equalizing unit 310, and does not include the heat sink 320. The heat dissipation module 300 may alternatively include the first heat equalizing unit 310 and the heat sink 320.

In this embodiment of this application, the fan 400 is mounted on the heat dissipation module 300, so that the fan 400 is mounted on the housing assembly 100 through the heat dissipation module 300. In this way, efficiency of assembling the heat dissipation module 300 and the fan 400 in the mounting cavity 600 is high, which helps improve efficiency of overall assembly of the electronic device.

In an embodiment in which the heat dissipation module 300 includes the first heat equalizing unit 310, the fan 400 is mounted on the first heat equalizing unit 310. In this way, mounting between the fan 400 and the heat dissipation module 300 is convenient. In addition, when the heat dissipation module 300 further includes the heat sink 320, the fan 400 blows air towards the heat sink 320.

In an embodiment in which the first heat equalizing unit 310 penetrates into the through-wall hole, the fan 400 may be mounted on a surface of the part that is of the first heat equalizing unit 310 and that is located in the ventilation cavity 620. Along an extension direction of the air duct 500, the fan 400 may be located between the heat sink 320 and the air inlet 130.

In this embodiment of this application, the heat dissipation module 300 is mounted on the main board 900, so that the heat dissipation module 300 is mounted on the housing assembly 100 through the main board 900. On a basis of implementing installation of the heat dissipation module 300 in the housing assembly 100, this is conducive to suppressing heat transfer between the heat dissipation module 300 and the housing assembly 100. In addition, it is also convenient to form thermal resistance between the heat dissipation module 300 and the housing assembly 100 through the first gap 710.

It may be understood that the heat dissipation module 300 may be locked on the main board 900 by using a fastener, a fastener structure, or the like. The heat dissipation module 300 may alternatively be locked on the heat emitting unit 200 by using a fastener, a fastener structure, or the like, so that the heat dissipation module 300 is mounted on the main board 900 through the heat emitting unit 200.

In an embodiment in which the heat dissipation module 300 includes the first heat equalizing unit 310, the first heat equalizing unit 310 is mounted on the main board 900.

In some other examples, the heat dissipation module 300 may be mounted on an inner wall of the housing assembly 100 by using a support made of a material with a low thermal conductivity, and the thermal resistance member 720 may include the support.

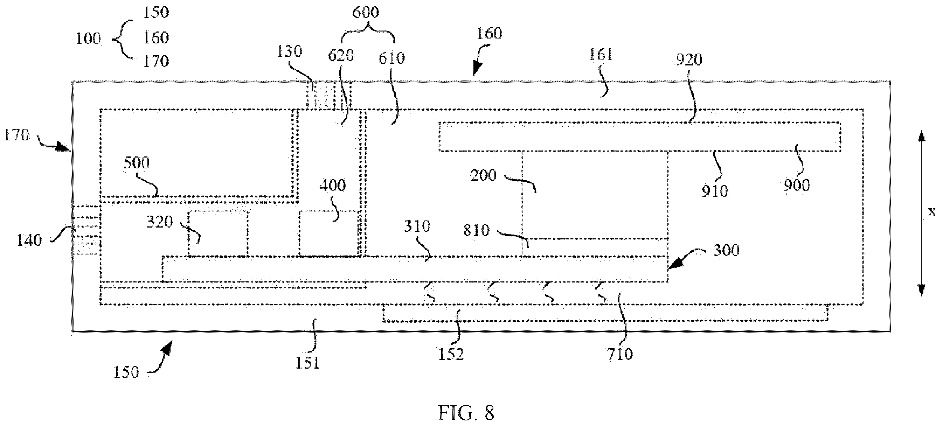

FIG. 8 is an internal diagram of still another electronic device according to an embodiment of this application.

As shown in FIG. 8, with reference to FIG. 7, in this embodiment of this application, the first side wall structure 150 further includes a second heat equalizing unit 152. The second heat equalizing unit 152 is disposed on an inner wall of the first side wall 151. In this way, temperature uniformity at all parts of the first side wall structure 150 can be good, which helps improve heat dissipation efficiency of natural heat dissipation performed by using the housing assembly 100.

In an embodiment in which the second heat equalizing unit 152 is disposed on the inner wall of the first side wall 151, for the heat dissipation module 300 connected to the heat emitting unit 200 mounted on the first side surface 910, an orthographic projection of the heat dissipation module 300 in the thickness direction of the main board 900 at least partially overlaps an orthographic projection of the second heat equalizing unit 152 in the thickness direction of the main board 900. In this way, when the housing assembly 100 is at a temperature at which user experience is good and performance of a component such as the display 1 mounted on the surface of the housing assembly 100 is not easily affected, this is conducive to transferring heat on the heat dissipation module 300 to the first side wall structure 150, so that the heat generated by the heat emitting unit 200 can be naturally dissipated through the housing assembly 100 efficiently.

It may be understood that, for the heat dissipation module 300 connected to the heat emitting unit 200 mounted on the first side surface 910, a thermal resistance between the heat dissipation module 300 and the first side wall 151 is greater than a thermal resistance between the heat dissipation module 300 and the second heat equalizing unit 152. The heat dissipation module 300 transfers heat to the housing assembly 100 mainly through the second heat equalizing unit 152. The thermal resistance between the heat dissipation module 300 and the second heat equalizing unit 152 determines a thermal conductivity between the heat dissipation module 300 and the housing assembly 100.

For example, the second heat equalizing unit 152 may include one or more of a vapor chamber, a heat pipe, a graphite flake, and the like.

In an embodiment in which the heat dissipation module 300 includes the first heat equalizing unit 310, for the heat dissipation module 300 connected to the heat emitting unit 200 mounted on the first side surface 910, an orthographic projection of the first heat equalizing unit 310 of the heat dissipation module 300 in the thickness direction of the main board 900 at least partially overlaps the orthographic projection of the second heat equalizing unit 152 in the thickness direction of the main board 900.

In some examples, the heat emitting unit 200 is mounted on the first side surface 910. In other words, the heat emitting unit 200 is not mounted on the second side surface 920.

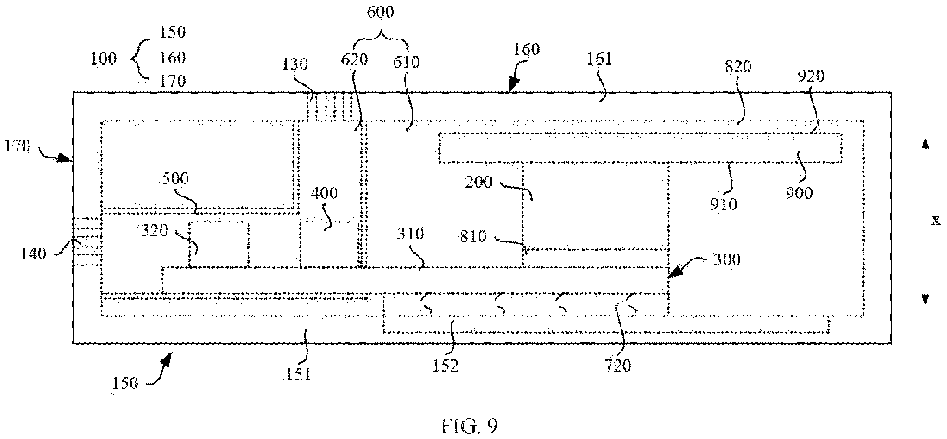

FIG. 9 is an internal diagram of still another electronic device according to an embodiment of this application.

As shown in FIG. 9, in some examples in which the heat emitting unit 200 is mounted on the first side surface 910, there is a second gap 820 between the second side surface 920 and the inner wall of the housing assembly 100. In other words, there is a second gap 820 between the second side surface 920 and a second side wall structure 160. In this way, a structure of the electronic device is simple. In addition, there is thermal resistance between the main board 900 and the housing assembly 100, which is conducive to controlling a temperature of the housing assembly 100, so that the housing assembly 100 is not prone to overheating.

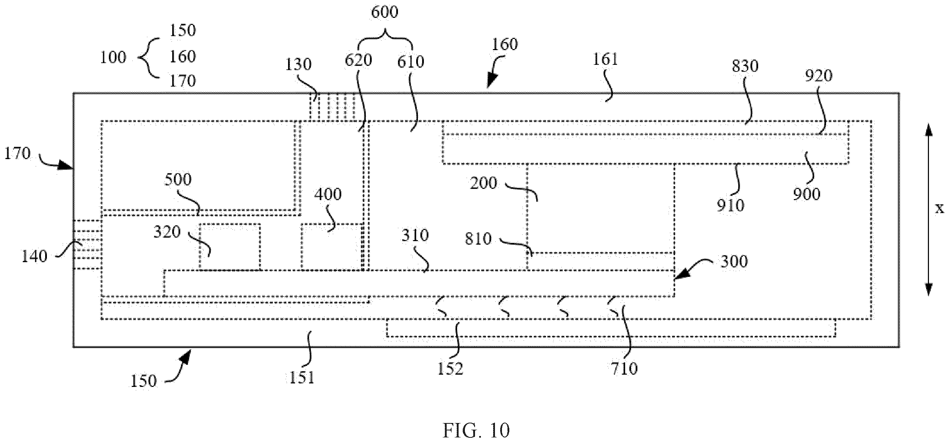

FIG. 10 is an internal diagram of still another electronic device according to an embodiment of this application.

As shown in FIG. 10, in some other examples in which the heat emitting unit 200 is mounted on the first side surface 910, the second side surface 920 is connected to the inner wall of the housing assembly 100 through a second thermal interface material 830. In other words, the second side surface 920 is connected to the inner wall of the second side wall structure 160 through the second thermal interface material 830. In this way, the heat generated by the heat emitting unit 200 may be transferred to the second side wall structure 160 through the main board 900 and the second thermal interface material 830, and an auxiliary heat dissipation path may be formed between the main board 900 and the second side wall structure 160, which helps improve heat dissipation efficiency of the heat emitting unit 200. In addition, the second thermal interface material 830 is disposed between the second side surface 920 and the second side wall structure 160, which is conducive to transferring heat on the main board 900 to the second side wall structure 160 efficiently.

In some examples in which the second side surface 920 is connected to the inner wall of the housing assembly 100 through the second thermal interface material 830, the second side surface 920 is connected to an inner wall of the second side wall 161 through the second thermal interface material 830.

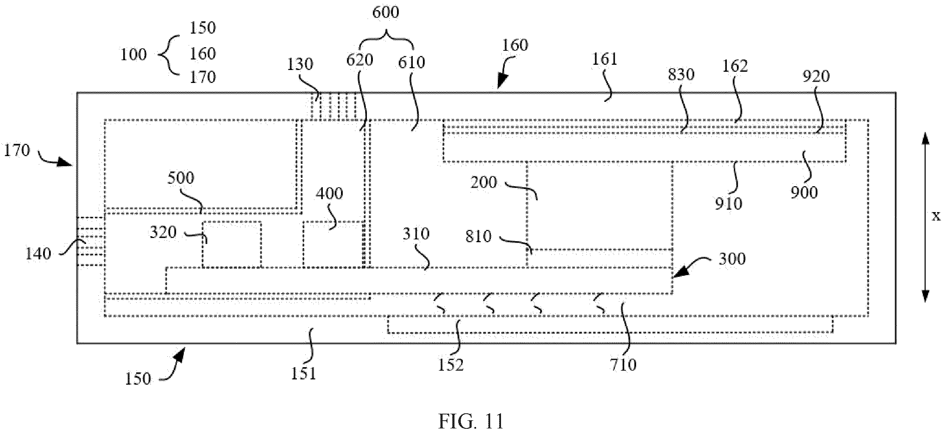

FIG. 11 is an internal diagram of still another electronic device according to an embodiment of this application.

As shown in FIG. 11, in some other examples in which the second side surface 920 is connected to the inner wall of the housing assembly 100 through the second thermal interface material 830, the second side wall structure 160 further includes a third heat equalizing unit 162, and the third heat equalizing unit 162 is disposed on the inner wall of the second side wall 161. In this way, temperature uniformity at all parts of the second side wall structure 160 can be good, which helps improve heat dissipation efficiency of natural heat dissipation performed by using the housing assembly 100.

In an embodiment in which the third heat equalizing unit 162 is disposed on the inner wall of the second side wall 161, the second side surface 920 is connected to the third heat equalizing unit 162 through the second thermal interface material 830.

This is conducive to improving efficiency of heat conduction between the main board 900 and the second side wall structure 160, and helps improve heat dissipation efficiency of the heat generated by the heat emitting unit 200 when natural heat dissipation is performed by using the housing assembly 100.

For example, the third heat equalizing unit 162 may include one or more of a vapor chamber, a heat pipe, a graphite flake, and the like.

In some other examples, the heat emitting unit 200 is mounted on both the first side surface 910 and the second side surface 920. For the heat dissipation module 300 connected to the heat emitting unit 200 mounted on the second side surface 920, a thermal resistance between the heat dissipation module 300 and the second side wall structure 160 is less than a thermal resistance between the heat dissipation module 300 and the first side wall structure 150, and the thermal resistance between the heat dissipation module 300 and the second side wall structure 160 is less than a thermal resistance between the heat dissipation module 300 and the enclosing wall structure 170. In other words, the heat dissipation module 300 transfers heat to the housing assembly 100 mainly through the second side wall structure 160. The thermal resistance between the heat dissipation module 300 and the second side wall structure 160 determines a thermal conductivity between the heat dissipation module 300 and the housing assembly 100.

In some examples in which the heat emitting unit 200 is mounted on both the first side surface 910 and the second side surface 920, the second side wall structure 160 may include a fourth heat equalizing unit (not shown), and the fourth heat equalizing unit is disposed on the inner wall of the second side wall 161. For the heat dissipation module 300 connected to the heat emitting unit 200 mounted on the second side surface 920, an orthographic projection of the heat dissipation module 300 in the thickness direction of the main board 900 at least partially overlaps an orthographic projection of the fourth heat equalizing unit in the thickness direction of the main board 900.

In the description of embodiments of this application, it should be noted that, unless otherwise defined and limited explicitly, terms "mounting", "connection", and "coupling" should be construed in a broad sense, which, for example, may be a fixed connection, or may be an indirect connection by using an intermediate medium, or may be an internal communication between two elements or an interaction relationship between two elements. Persons of ordinary skill in the art may understand specific meanings of the terms in embodiments of this application based on a specific situation.

In the specification, claims, and accompanying drawings of embodiments of this application, the terms "first", "second", "third", "fourth", and so on (if existent) are intended to distinguish between similar objects but do not necessarily indicate a specific order or sequence.

Finally, it should be noted that the foregoing embodiments are merely intended to describe the technical solutions of embodiments of this application, and are not intended to limit embodiments of this application. Although embodiments of this application are described in detail with reference to the foregoing embodiments, persons of ordinary skill in the art should understand that they may still make modifications to the technical solutions described in the foregoing embodiments or make equivalent replacements to some or all technical features thereof. These modifications or replacements do not make the essence of the corresponding technical solutions depart from the scope of the technical solutions of embodiments of this application.

## Claims

1. An electronic device, comprising a housing assembly, a main board, a heat emitting unit, a fan, and a heat dissipation module, wherein
there is a mounting cavity in the housing assembly;
the main board, the heat emitting unit, and the heat dissipation module are all disposed in the mounting cavity;
the main board is mounted on the housing assembly, one side of the heat emitting unit is mounted on the main board, and another side of the heat emitting unit is connected to the heat dissipation module;
the heat dissipation module and the housing assembly are disposed at an interval, and there is a thermal resistance structure between the heat dissipation module and the housing assembly; and
the housing assembly has an air inlet and an air outlet, both the air inlet and the air outlet are in communication with the mounting cavity, and the fan is configured to drive air at at least a part of the heat dissipation module to flow out of the mounting cavity through the air outlet.

2. The electronic device according to claim 1, wherein the heat dissipation module comprises a first heat equalizing unit; and
the heat emitting unit is connected to the first heat equalizing unit, and the fan is configured to drive air at at least a part of the first heat equalizing unit to flow out of the mounting cavity through the air outlet.

3. The electronic device according to claim 1, wherein the heat dissipation module comprises a first heat equalizing unit and a heat sink;
the heat emitting unit is connected to the first heat equalizing unit, and the heat sink is disposed on a surface of the first heat equalizing unit; and
the fan is configured to drive air at the heat sink to flow out of the mounting cavity through the air outlet.

4. The electronic device according to claim 3, wherein in a length direction of the main board or in a width direction of the main board, the heat sink and the main board are disposed at an interval.

5. The electronic device according to any one of claims 2 to 4, wherein in a thickness direction of the main board, the heat emitting unit is located between the first heat equalizing unit connected to the heat emitting unit and the main board, and the first heat equalizing unit is connected to a surface of a side that is of the heat emitting unit and that faces away from the main board.

6. The electronic device according to claim 5, wherein the heat sink of the heat dissipation module is disposed on a surface of a side that is of the first heat equalizing unit and that faces the main board.

7. The electronic device according to any one of claims 1 to 6, wherein the thermal resistance structure comprises a gap located between the heat dissipation module and the housing assembly.

8. The electronic device according to any one of claims 1 to 7, wherein the thermal resistance structure comprises a thermal resistance member disposed between the heat dissipation module and the housing assembly, one side of the thermal resistance member is connected to the heat dissipation module, and another side of the thermal resistance member is connected to the housing assembly.

9. The electronic device according to any one of claims 1 to 8, wherein the housing assembly comprises a first side wall and a second heat equalizing unit, the main board comprises a first side surface, and the heat emitting unit is mounted on the first side surface;
the first side wall is opposite to the first side surface, the second heat equalizing unit is disposed on an inner wall of the first side wall, and the heat dissipation module is connected to the heat emitting unit mounted on the first side surface; and
an orthographic projection of the heat dissipation module in the thickness direction of the main board at least partially overlaps an orthographic projection of the second heat equalizing unit in the thickness direction of the main board.

10. The electronic device according to any one of claims 1 to 9, wherein there is an air duct in the housing assembly;
the mounting cavity comprises a ventilation cavity located in the air duct and a sealed cavity located outside the air duct;
the main board and the heat emitting unit are disposed in the sealed cavity, the air duct has a through-wall hole, the heat dissipation module penetrates into the through-wall hole, and the heat dissipation module is connected to the air duct at the through-wall hole in a sealed manner, so that the ventilation cavity is separated from the sealed cavity; and
both the air inlet and the air outlet are in communication with the ventilation cavity, a part that is of the heat dissipation module and that is located in the sealed cavity is connected to the heat emitting unit, and the fan is configured to drive air at a part that is of the heat dissipation module and that is located in the ventilation cavity to flow out of the ventilation cavity through the air outlet.

11. The electronic device according to any one of claims 1 to 10, wherein the fan is mounted in the mounting cavity.

12. The electronic device according to any one of claims 1 to 11, wherein the fan is mounted on the heat dissipation module.

13. The electronic device according to any one of claims 1 to 12, wherein the heat dissipation module is mounted on the main board.

14. The electronic device according to any one of claims 1 to 13, wherein the heat dissipation module is connected to the heat emitting unit through a first thermal interface material.

15. The electronic device according to any one of claims 1 to 14, wherein the electronic device further comprises a controller, and the controller is electrically connected to the fan; and
the controller is configured to: when a temperature of the electronic device is less than a preset temperature, control the fan to be turned off, and when the temperature of the electronic device is greater than or equal to the preset temperature, control the fan to be turned on.

16. The electronic device according to any one of claims 1 to 15, wherein the main board comprises a second side surface, the first side surface of the main board is disposed opposite to the second side surface, the heat emitting unit is mounted on the first side surface, and the second side surface is connected to an inner wall of the housing assembly through a second thermal interface material.
